# EUROPEAN PATENT SPECIFICATION

(11) **EP 2 620 230 B1**
(45) Date of publication and mention of the grant of the patent: **19.08.2015**
(21) Application number: 13151320.2
(22) Date of filing: 15.01.2013
(51) Int. Cl.: B08B 3/12

(54) **Cleaning apparatus, equipment, and method**
Reinigungsvorrichtung, Ausrüstung und Verfahren
Appareil de nettoyage, équipement et procédé

(30) Priority: 27.01.2012 JP 2012015450
(43) Date of publication of application: 31.07.2013
(73) Proprietor: Siltronic AG, 81737 München (DE)
(72) Inventor: Mori, Yoshihiro, Shunan, Yamaguchi 745-0651 (JP); Haibara, Teruo, Hikari, Yamaguchi 743-0011 (JP); Tanabe, Etsuko, Hikari, Yamaguchi 743-0031 (JP); Uchibe, Masashi, Hikari, Yamaguchi 743-0072 (JP)
(74) Representative: Baar, Christian

(56) References cited:
- JP-A- H10 172 948
- JP-A- 2001 046 991
- US-A- 6 138 698
- US-A1- 2005 061 355

## Description

### Technical Field

The present invention relates to a cleaning apparatus, equipment and method, and particularly to an ultrasonic cleaning apparatus, equipment and method.

### Background Art

A conventionally known cleaning method and apparatus is used to dip a substrate or a similar object in a cleaning liquid and thus expose it to an ultrasonic wave to clean it. To clean the object's entire surface uniformly, the cleaning method is required to expose the entire surface to the ultrasonic wave. However, the ultrasonic wave is partially interrupted by a structure (e.g., a holding member for holding the object) in a cleaning tank holding the cleaning liquid, and as a result the object has a surface which is not directly exposed to the ultrasonic wave. In order to solve such a problem, various techniques have conventionally been proposed.

For example, Japanese Patent Laying-Open No. 2009-231668 indicates that an ultrasonic refraction member which can be swung is disposed at a bottom of a cleaning tank, and the ultrasonic refraction member is swung to vary a direction in which an ultrasonic wave travels in the cleaning tank. JP2009-231668 indicates that this minimizes a portion of an object to be cleaned that is insufficiently exposed to the ultrasonic wave.

Furthermore, Japanese Patent Laying-Open No. 2001-057354 indicates that a cleaning tank having an ultrasonic oscillation source provided on a bottom surface thereof has a cylindrical rod disposed on the bottom surface thereof to disperse an ultrasonic wave in the cleaning tank. The document indicates that this allows an object, or a substrate, disposed in the cleaning tank to be cleaned substantially uniformly.

### Problems to be Solved by the Invention

However, the apparatus disclosed in JP2009-231668 is required to have a mechanical structure in the cleaning tank to swing the ultrasonic refraction member, and as a result the apparatus is complex and expensive. Furthermore, while the apparatus disclosed in JP2001-057354 allows a substrate to have a surface having a relatively large area exposed to an ultrasonic wave, the apparatus cannot adjust ultrasonic exposure in conformity to a cleaning condition, and it is thus difficult to completely entirely expose the surface to the ultrasonic wave.

The present invention has been made to solve the above described issue and it contemplates a cleaning apparatus, equipment and method that can have a relatively simple configuration to clean an object without an area which is not directly exposed to an ultrasonic wave.

### Means for Solving the Problems

The present invention provides a cleaning apparatus comprising a cleaning tank, a coupling tank, an ultrasonic wave generation unit, and a modification unit. The cleaning tank holds a cleaning liquid for cleaning an object to be cleaned. The coupling tank holds an intermediate medium and is disposed such that the cleaning tank has a portion in contact with the intermediate medium. The ultrasonic wave generation unit is provided at the coupling tank and ultrasonically vibrates the cleaning liquid via the intermediate medium. The modification unit modifies a difference in sonic velocity between the cleaning liquid and the intermediate medium.

Varying a difference in sonic velocity between the cleaning liquid and the intermediate medium can modify a condition applied to refract an ultrasonic wave at a boundary of the cleaning tank and the coupling tank. This allows the ultrasonic wave to travel through the cleaning tank in a modified direction and can thus reduce an area of the object (e.g., a substrate) held in the cleaning liquid that is shadowed by a holding member or the like holding the object (i.e., an area that is not directly exposed to the ultrasonic wave).

The present invention provides cleaning equipment equipped with a plurality of cleaning units cleaning an object to be cleaned with a cleaning liquid, and at least one of the plurality of cleaning units is the cleaning apparatus as described above. At least one cleaning unit that has the configuration of the present cleaning apparatus can have a condition (applied to refract an ultrasonic wave at an interface of the cleaning tank and the intermediate medium) set to be different than another cleaning unit. The object cleaned through the cleaning units sequentially can be cleaned without a surface having a large area which is shadowed and thus not directly exposed to an ultrasonic wave.

The present invention provides a cleaning method comprising the steps of: disposing in a cleaning liquid held in a cleaning tank an object to be cleaned; and ultrasonically vibrating the cleaning liquid via an intermediate medium in contact with the cleaning tank to clean the object, and the step of ultrasonically vibrating includes the steps of: ultrasonically vibrating the cleaning liquid with the cleaning liquid and the intermediate medium allowing sonic velocities, respectively, having a first difference; and ultrasonically vibrating the cleaning liquid with the cleaning liquid and the intermediate medium allowing sonic velocities, respectively, having a second difference different from the first difference. The first and different, second differences can vary for each cleaning step a condition applied to refract an ultrasonic wave at a boundary of the cleaning tank and the intermediate medium. As a result, the object to be cleaned (e.g., a substrate) held in the cleaning liquid does not have a large area shadowed by a holding member or the like (i.e., a large area that is not directly exposed to an ultrasonic wave).

The present invention provides a cleaning method comprising the steps of: disposing in a first cleaning liquid held in a first cleaning tank an object to be cleaned; ultrasonically vibrating the first cleaning liquid via a first intermediate medium in contact with the first cleaning tank to clean the object; disposing the object in a second cleaning liquid held in a second cleaning tank; and ultrasonically vibrating the second cleaning liquid via a second intermediate medium in contact with the second cleaning tank to clean the object. The first cleaning liquid and the first intermediate medium allow sonic velocities, respectively, having a first difference and the second cleaning liquid and the second intermediate medium allow sonic velocities, respectively, having a second difference, and the first and second differences are different from each other.

A single coupling tank holds an intermediate medium without having the intermediate medium's condition modified as occasion would require. Rather, first and second intermediate media's respective conditions can be fixed, and the object can thus be cleaned continuously. This allows cleaning to be done in a more efficient and hence less costly method.

### Effects of the Invention

The present invention can thus provide a cleaning apparatus, equipment and method allowing an object to be cleaned without an area which is not directly exposed to an ultrasonic wave.

### Brief Description of the Drawings

Fig. 1 represents a concept in a schematic diagram of a cleaning apparatus in accordance with the present invention.
Fig. 2 is a schematic diagram in cross section showing an explicatory example of the cleaning apparatus not forming a part of the present invention.
Fig. 3 is a flowchart for illustrating a cleaning method not forming a part of the present invention.
Fig. 4 is a flowchart for illustrating a cleaning process of Fig. 3.
Fig. 5 is a flowchart for illustrating an example of a step S23 of Fig. 4.
Fig. 6 is a flowchart for illustrating another example of step S23 of Fig. 4.
Fig. 7 is a schematic diagram in cross section showing an exemplary variation of the cleaning apparatus shown in Fig. 2.
Fig. 8 is a schematic diagram in cross section showing an embodiment of the cleaning apparatus in accordance with the present invention.
Fig. 9 is a flowchart for illustrating a cleaning process using the cleaning apparatus shown in Fig. 8.
Fig. 10 is a schematic diagram in cross section showing cleaning equipment in accordance with the present invention.
Fig. 11 is a flowchart for illustrating a cleaning process employing the cleaning equipment shown in Fig. 10.
Fig. 12 is a schematic diagram for studying an angle of refraction of an ultrasonic wave in the present invention.
Fig. 13 is a schematic diagram showing an example of calculating an angle of refraction of an ultrasonic wave in the present invention.
Fig. 14 is a schematic diagram showing another example of calculating an angle of refraction of an ultrasonic wave in the present invention.

### Reference Signs List

1: cleaning apparatus
2: cleaning tank
3: coupling tank
4: cleaning liquid
5: intermediate medium
6: ultrasonic wave generation unit
7: modification unit
10: substrate
11: holding member
12: area
13, 15, 16, 20, 32, 33, 47, 48: arrow
17: heater
18, 19: pipe
21: control unit
27, 28: automatic valve
41-43: cleaning unit
46: bottom surface
49: perpendicular
100: cleaning equipment

### Best Modes for Carrying out the Invention

Hereinafter, the present invention in embodiment will be described with reference to the drawings. In the figures, identical or corresponding components are identically denoted and will not be described repeatedly.

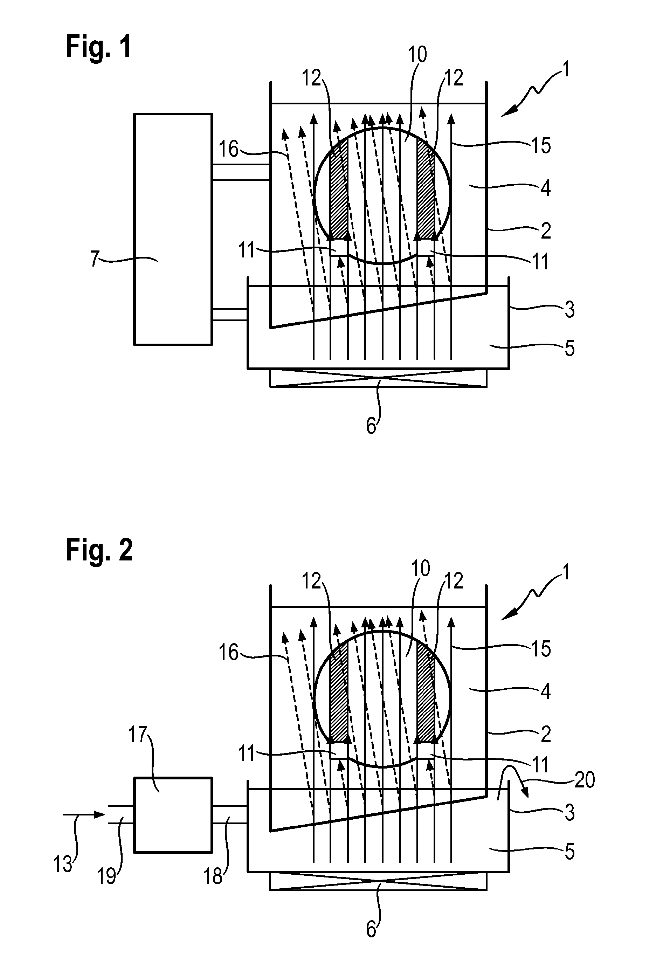

Reference will be made to Fig. 1 to describe the present cleaning apparatus in a basic configuration. As shown in Fig. 1, the present invention provides a cleaning apparatus 1 including a cleaning tank 2, a coupling tank 3, an ultrasonic wave generation unit 6, and a modification unit 7. Cleaning tank 2 holds a cleaning liquid 4 for cleaning a substrate 10 as an object to be cleaned. Coupling tank 3 holds an intermediate medium 5, and cleaning tank 2 has a portion (a bottom and a portion of a side wall) in contact with intermediate medium 5. The bottom of cleaning tank 2 inclines relative to that of coupling tank 3. Ultrasonic wave generation unit 6 is provided at coupling tank 3, and ultrasonically vibrates cleaning liquid 4 via intermediate medium 5. Ultrasonic wave generation unit 6 is connected to a bottom wall of coupling tank 3 and thus fixed thereto. Modification unit 7 modifies a difference in sonic velocity between cleaning liquid 4 and intermediate medium 5. Modification unit 7 may be connected to one or both of coupling tank 3 and cleaning tank 2. While the difference in sonic velocity can be modified in any methods, it can be done so for example by modifying intermediate medium 5 in temperature or modifying cleaning liquid 4 in temperature, both options which do not form part of the present invention, or modifying the intermediate medium in composition, in accordance with the present invention. Modification unit 7 has a specific configuration, by way of example, as will be described later.

Cleaning apparatus 1 thus structured can modify a difference in sonic velocity between cleaning liquid 4 and intermediate medium 5 to modify a condition applied to refract an ultrasonic wave that is emitted from ultrasonic wave generation unit 6 at a boundary of cleaning tank 2 and coupling tank 3 (more specifically, a boundary portion of cleaning liquid 4 held in cleaning tank 2 and intermediate medium 5 in contact with the bottom of cleaning tank 2). As a result, an ultrasonic wave output from ultrasonic wave generation unit 6 in a direction of an arrow 15 is refracted at the boundary portion so that the ultrasonic wave can be modified in direction from that of arrow 15 to that of an arrow 16 and thus travel through cleaning tank 2 in the latter direction.

If the object to be cleaned, or substrate 10, held in cleaning liquid 4 is exposed to an ultrasonic wave traveling along arrow 15, substrate 10 has an area 12 shadowed by holding member 11 or the like for holding substrate 10 (i.e., a portion which is not directly exposed to the ultrasonic wave). Modifying a condition applied to refract an ultrasonic wave at the boundary portion to modify the ultrasonic wave in direction from arrow 15 to arrow 16 to travel through cleaning liquid 4 in the latter direction can minimize such a shadowed area 12 to a substantially negligible level.

Cleaning apparatus 1 in a specific exemplary configuration not forming part of the present invention will now be described with reference to Fig. 2. The cleaning apparatus 1 shown in Fig. 2 basically has a configuration similar to the Fig. 1 cleaning apparatus 1, except that the former has modification unit 7 shown in Fig. 1 implemented as a heater 17 connected to coupling tank 3 via a pipe 18 as a temperature adjustment unit. Heater 17 is connected to a source of intermediate medium 5 (e.g., a tank having intermediate medium 5 stored therein) via a pipe 19. Intermediate medium 5 is supplied via pipe 19, heater 17, and pipe 18 to coupling tank 3, as indicated by an arrow 13. Heater 17 can heat intermediate medium 5 to raise the temperature of intermediate medium 5 and thus supply it to coupling tank 3. Coupling tank 3 receives intermediate medium 5, which overflows from an upper portion of coupling tank 3 to outside coupling tank 3, as indicated by an arrow 20.

Modification unit 7 (see Fig. 1) that includes heater 17 that is a heating member serving as a temperature adjustment unit to modify intermediate medium 5 in temperature, as indicated in Fig. 2, allows intermediate medium 5 to be adjusted in temperature without modifying intermediate medium 5 in composition or the like. As sonic velocity in intermediate medium 5 varies with the temperature of intermediate medium 5, thus controlling intermediate medium 5 in temperature consequently allows sonic velocity in intermediate medium 5 to be controlled. This allows the apparatus to have a relatively simple configuration to modify a condition applied to refract an ultrasonic wave at the boundary portion of cleaning tank 2 and coupling tank 3. As a result, cleaning apparatus 1 can be manufactured at a reduced cost. Note that intermediate medium 5 may be controlled in temperature by a cooler device rather than heater 17.

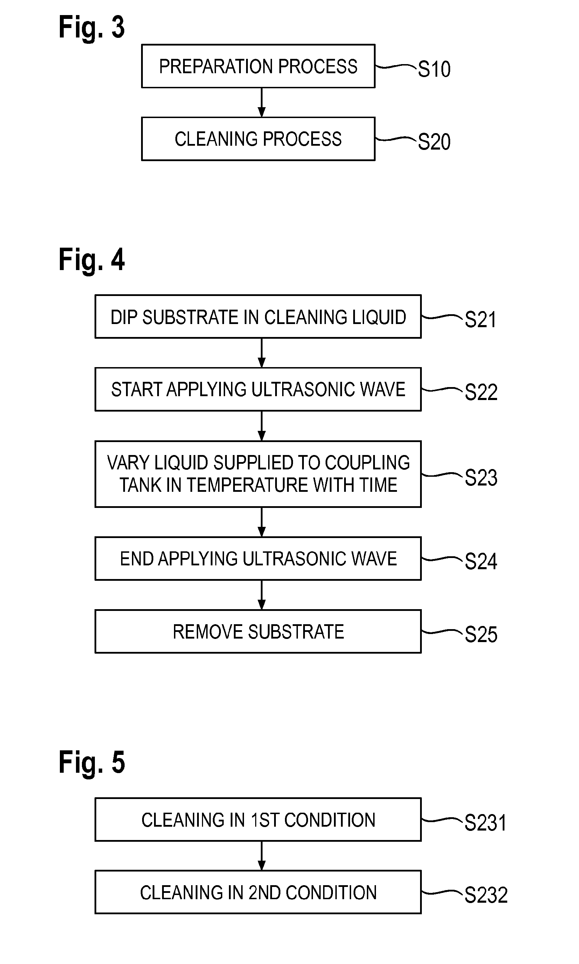

Reference will now be made to Fig. 3 to Fig. 6 to describe a cleaning method not forming part of the present invention using cleaning apparatus 1 shown in Fig. 2. With reference to Fig. 3, the present cleaning method initially provides a preparation process (S10). In this process (S10), cleaning liquid 4 and intermediate medium 5, as predetermined, are introduced into the cleaning apparatus 1 cleaning tank 2, coupling tank 3, and the like. Furthermore, an object to be cleaned, or substrate 10, is also prepared.

Subsequently, a cleaning process (S20) shown in Fig. 3 is performed. This process (S20) is performed specifically through steps shown in Fig. 4. With reference to Fig. 4, in this process (S20), a step (S21) is performed to dip a substrate in the cleaning liquid as the step of disposing the object in cleaning liquid 4 held in cleaning tank 2. In this step (S21), the object to be cleaned, or substrate 10, is disposed in cleaning liquid 4, as shown in Fig. 2. Substrate 10 is supported by holding member 11 provided in cleaning tank 2.

Subsequently, as shown in Fig. 4, applying an ultrasonic wave is started (step S22). In this step, ultrasonic wave generation unit 6 generates an ultrasonic wave and cleaning liquid 4 is exposed thereto via intermediate medium 5. Such ultrasonic exposure starts cleaning substrate 10.

Subsequently, a liquid supplied to the coupling tank (or intermediate medium 5) is varied in temperature with time (step S23). More specifically, intermediate medium 5 of a first temperature is supplied to coupling tank 3 to apply a first condition to perform a cleaning step (S231), as indicated in Fig. 5. Intermediate medium 5 may be set at the first temperature by operating heater 17 to heat intermediate medium 5, or without operating heater 17 intermediate medium 5 of an initial temperature may be supplied to coupling tank 3. In cleaning liquid 4 the ultrasonic wave may travel in a direction indicated for example by arrow 15 shown in Fig. 2. Note that ultrasonic wave generation unit 6 can generate an ultrasonic wave for example having a frequency of 1 MHz and a watt density of 2.5 W/cm².

Subsequently, in step S23, a second condition is applied to perform a cleaning step (step S232), as shown in Fig. 5. In doing so, heater 17 heats intermediate medium 5 to modify intermediate medium 5 in temperature from the first temperature to a different, second temperature. Thus modifying intermediate medium 5 in temperature modifies a condition applied to refract the ultrasonic wave at the bottom of cleaning tank 2, and accordingly, in cleaning liquid 4, the ultrasonic wave travels in a direction different from that in which the ultrasonic wave travels in step S231. For example, in step S232, the ultrasonic wave may travel through cleaning liquid 4 along arrow 16 indicated in Fig. 2.

Heater 17 that modifies the temperature of intermediate medium 5 supplied to coupling tank 3 allows an ultrasonic wave to travel through cleaning liquid 4 in a modified direction, and as a result can reduce area 12 in size that would otherwise be shadowed by holding member 11 and thus not directly be exposed to the ultrasonic wave. Steps S231 and S232 may each be performed for example for a period of 2 minutes. Furthermore, intermediate medium 5 can be water (pure water), and the first temperature can for example be 25 degrees centigrade and the second temperature can for example be 80 degrees centigrade. Note that the first temperature and the second temperature can be set for example at any value within a range from 25 to 80 degrees centigrade.

Subsequently, as shown in Fig. 4, applying the ultrasonic wave ends (step S24). Specifically, in this step (S24), ultrasonic wave generation unit 6 stops generating the ultrasonic wave. The application of (or exposure to) the ultrasonic wave can be ended for example when an ultrasonic wave exposure time has attained a predetermined prescribed period.

Subsequently, the substrate is removed (step S25). In this step, substrate 10 having been cleaned is removed from cleaning tank 2. Substrate 10 can thus be cleaned.

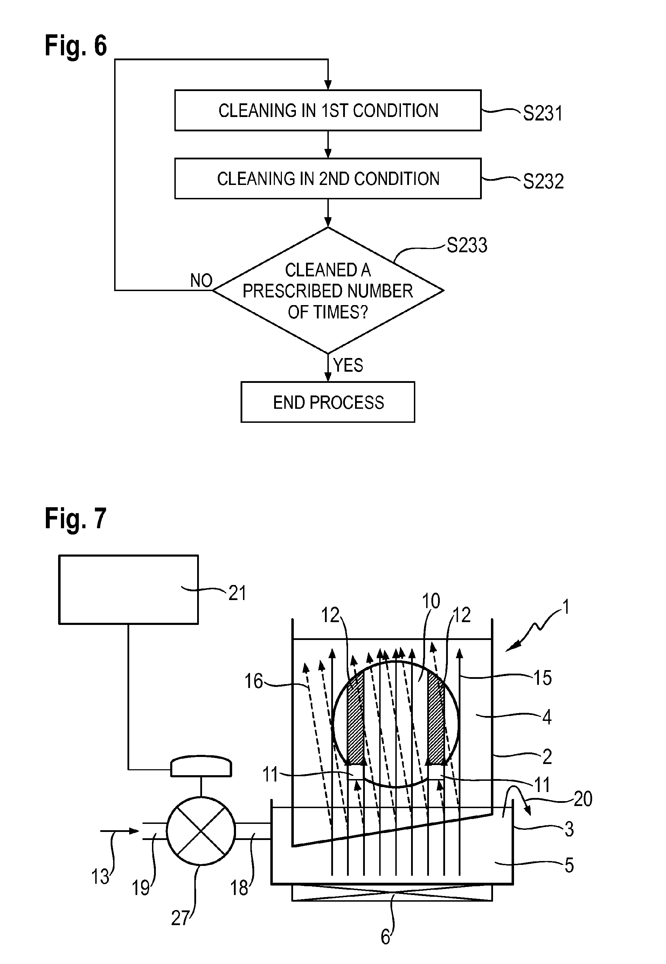

Note that while the Fig. 4 step S23 may be performed to apply the first condition and the second condition, each only once, in cleaning, as indicated in Fig. 5, the step may alternatively be performed to perform the cleaning step in the first condition (S231) and the cleaning step in the second condition (S232) in turn more than once repeatedly, as indicated in Fig. 6. More specifically, as indicated in Fig. 6, the cleaning step in the first condition (S231) and the cleaning step in the second condition (S232) are performed and thereafter a step (S233) is performed to determine whether steps S231, S232 have been performed a predetermined number of times. If not (No at S233), steps S231, S232 are again performed. Steps S231, S232 may be performed cyclically as prescribed (e.g., each for a period of 2 minutes). If steps S231, S232 have been performed the predetermined number of times (Yes at S233), the Fig. 6 process ends and a subsequent step is performed. The cleaning step in the first condition and the cleaning step in the second condition that are repeated more than once ensure that substrate 10 is better cleaned.

Reference will now be made to Fig. 7 to describe the Fig. 2 cleaning apparatus 1 in an exemplary variation, not forming part of the present invention. The Fig. 7 cleaning apparatus 1 is basically similar in configuration to the Fig. 2 cleaning apparatus 1, except that the former has a portion corresponding to modification unit 7 (see Fig. 1) that is differently configured, i.e., heater 17 is replaced with an automatic valve 27 connected to coupling tank 3 via pipe 18 and capable of varying the flow rate of intermediate medium 5. A control unit 21 is connected to automatic valve 27. Control unit 21 can control the valve position of automatic valve 27. A flow rate adjustment unit, or automatic valve 27, is connected via pipe 19 to a unit supplying degassed water as intermediate medium 5. Note that degassed water is water having a dissolved-gas concentration reduced to 2 ppm or less.

It is known that when degassed water is exposed to an ultrasonic wave, the degassed water's temperature rapidly increases. Automatic valve 27 and control unit 21 that vary an amount of intermediate medium 5 (or degassed water) supplied into coupling tank 3 allow the degassed water to be retained in coupling tank 3 (i.e., exposed to an ultrasonic wave) for a varying period of time and, as a result, controlled in temperature. Intermediate medium 5 or the degassed water varied in temperature allows sonic velocity in intermediate medium 5 to be controlled, similarly as done in the Fig. 2 cleaning apparatus 1. This allows the apparatus to have a relatively simple configuration to modify a condition applied to refract an ultrasonic wave at the boundary portion of cleaning tank 2 and coupling tank 3.

When the Fig. 7 cleaning apparatus 1 is used to perform a cleaning method, the cleaning method is basically similar to the Figs. 3-6 cleaning method. Note that, in the Fig. 4 step S23, intermediate medium 5 is varied in temperature with time via automatic valve 27 of Fig. 7 so that intermediate medium 5, e.g. degassed water, has a varied flow rate. For example, the cleaning step in the first condition (S231) is performed with automatic valve 27 controlled to allow the degassed water to be introduced into coupling tank 3 continuously for one minute in an amount of 5 liters/min. In contrast, the cleaning step in the second condition (S232) is performed with automatic valve 27 controlled to zero the amount of the degassed water introduced into coupling tank 3. This allows the degassed water exposed to an ultrasonic wave to be heated to a maximum of approximately 80 degrees centigrade. This can be as effective as the Figs. 3-6 cleaning method.

### First Embodiment

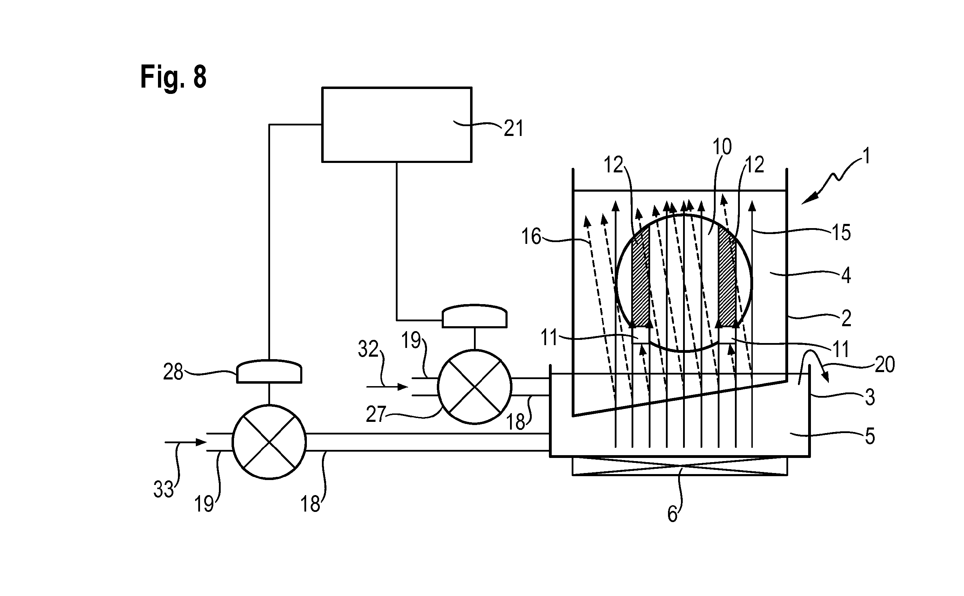

With reference to Fig. 8, the present invention provides cleaning apparatus 1 in a first embodiment, as will be described hereinafter. The Fig. 8 cleaning apparatus 1 basically has a configuration similar to the Fig. 2 cleaning apparatus 1, except that the former has a portion corresponding to modification unit 7 (see Fig. 1) that is differently configured. Specifically, the Fig. 8 cleaning apparatus 1 is provided with pipes of two systems, respectively, to supply coupling tank 3 with an intermediate medium. In one system, pipe 18 connected to coupling tank 3 is connected to automatic valve 27 which is connected via pipe 19 to a water supply source (a water tank for example). Automatic valve 27 is supplied with water through pipe 19, as indicated by an arrow 32. Furthermore, in the other system, pipe 18 connected to coupling tank 3 has an automatic valve 28 connected thereto. Furthermore, automatic valve 28 is connected to an ethanol supply source (an ethanol tank for example) via pipe 19. Automatic valve 28 is supplied with ethanol through pipe 19, as indicated by an arrow 33.

Automatic valves 27 and 28 are electrically connected to control unit 21 and operable in response to a control signal issued from control unit 21 to adjust their valve positions. The systems that allow water and ethanol, respectively, to be supplied to coupling tank 3 at predetermined flow rates, respectively, allow coupling tank 3 to hold intermediate medium 5 having a composition (more specifically, a water/ethanol ratio) adjusted as desired. Intermediate medium 5 thus modified in composition allows sonic velocity therein to be varied. As a result an effect similar to that of the Fig. 2 cleaning apparatus 1 can be obtained. For example, automatic valves 27 and 28 may be controlled to allow the cleaning step in the first condition (S231) to be performed with water alone supplied to coupling tank 3 and the cleaning step in the second condition (S232) to be performed with ethanol alone supplied to coupling tank 3. Steps S231, S232 may be performed cyclically as prescribed (e.g., each for a period of 2 minutes). This allows coupling tank 3 to hold intermediate medium 5 having a continuously and cyclically varying composition.

Note that while herein the systems feed media of water and ethanol by way of example, the systems may feed any media that allow different sonic velocities, respectively, (e.g., that are different in composition).

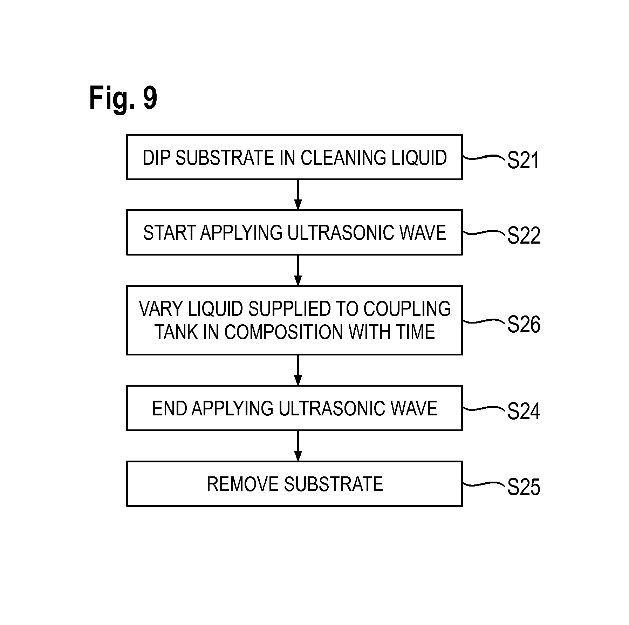

Reference will now be made to Fig. 9 to describe a cleaning method using the Fig. 8 cleaning apparatus. The cleaning method using the Fig. 8 cleaning apparatus 1 is basically similar to the Figs. 3-6 cleaning method. However, the former differs from the latter in that for the Fig. 3 cleaning process S20, a process shown in Fig. 9, rather than the Fig. 4 process, is performed. Herein, the Fig. 9 process is basically similar to the Fig. 4 process. That is, as well as the Fig. 4 process, the Fig. 9 process includes the step of dipping a substrate in a cleaning liquid (S21) and the step of starting applying an ultrasonic wave (S22). Then, the Fig. 4 step S23 is replaced in the Fig. 9 process with the step of varying a liquid supplied to the coupling tank (or intermediate medium 5) in composition with time (S26).

More specifically, intermediate medium 5 of a first composition is supplied to coupling tank 3 to apply a first condition to perform a cleaning step (S231), as indicated in Fig. 5. To allow intermediate medium 5 to have the first composition, automatic valves 27 and 28 are controlled by control unit 21 to have prescribed valve positions, respectively, to provide intermediate medium 5 of water and ethanol at a first ratio. At the time, cleaning liquid 4 may pass an ultrasonic wave in a direction indicated for example by arrow 15 shown in Fig. 2.

Subsequently, in step S26, a second condition is applied to perform a cleaning step (S232), as indicated in Fig. 5. At the time, automatic valves 27 and 28 have their valve travels adjusted to be different from those in the cleaning step in the first condition (S231), i.e., so that the intermediate medium 5 water/ethanol ratio in coupling tank 3 is changed and thus adjusted from the first ratio to a different, second ratio. This varies intermediate medium 5 in composition from the first composition to a different, second composition. Thus modifying intermediate medium 5 in composition modifies a condition applied to refract an ultrasonic wave at the bottom of cleaning tank 2, and accordingly, cleaning liquid 4 allows the ultrasonic wave to travel therethrough in a direction different from that in which the ultrasonic wave travels in step S231. For example, in step S232, the ultrasonic wave may travel through cleaning liquid 4 along arrow 16 indicated in Fig. 2. Control unit 21 and automatic valves 27 and 28 that operate to modify the composition of intermediate medium 5 supplied to coupling tank 3 allow an ultrasonic wave to travel through cleaning liquid 4 in a modified direction, and as a result can reduce area 12 in size that would otherwise be shadowed by holding member 11 and thus not directly be exposed to the ultrasonic wave.

Subsequently, as done in the Fig. 4 process, applying the ultrasonic wave ends (step S24) and the substrate is removed (step S25). The Fig. 8 cleaning apparatus 1 can thus be used to clean substrate 10.

### Second Embodiment

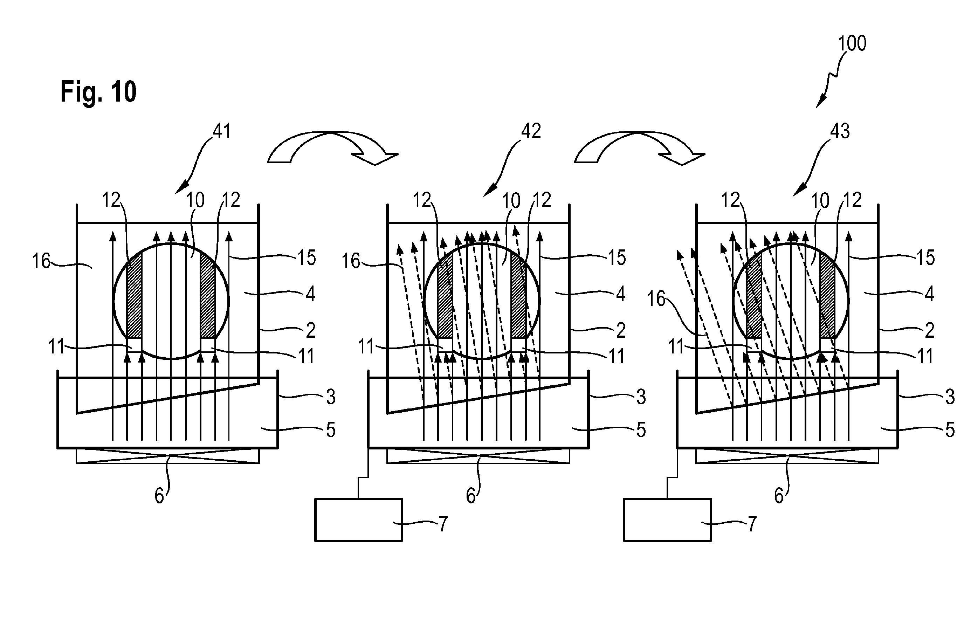

With reference to Fig. 10, the present invention in a third embodiment provides cleaning equipment 100, as will be described hereinafter. As shown in Fig. 10, cleaning equipment 100 comprises three cleaning units 41-43 and a substrate transfer member (not shown). Cleaning units 42 and 43 are basically similar in configuration to the Fig. 1 cleaning apparatus 1, and include modification unit 7 connected to coupling tank 3. Modification unit 7 has a configuration corresponding to the modification unit of cleaning apparatus 1 shown in Fig. 8. Cleaning unit 41 also has a configuration basically similar to the Fig. 1 cleaning apparatus 1, except that the former does not include modification unit 7. Accordingly in cleaning unit 41 an ultrasonic wave travels through cleaning tank 2 in a direction fixed as indicated by an arrow 15.

In contrast, cleaning units 42 and 43 are provided with modification unit 7, and thus allow an ultrasonic wave to be modified in direction from that of arrow 15 to that of arrow 16 and thus travel through cleaning tank 2 in the latter direction. Furthermore, the Fig. 10 cleaning equipment 100 allows cleaning units 42 and 43 to each have a different difference in sonic velocity between cleaning liquid 4 and intermediate medium 5, as varied by modification unit 7. This allows cleaning units 42 and 43 to provide ultrasonic waves refracted at the bottom of cleaning tank 2 to different extents, respectively, and thus traveling through cleaning tank 2 in directions (along allow 16), respectively, that are different from each other. As a result, substrate 10 cleaned by a plurality of cleaning units 41, 42, 43 sequentially can substantially be free of area 12 that is shadowed by holding member 11 and thus not directly exposed to an ultrasonic wave. Furthermore, cleaning units 42 and 43 can each have a different difference in sonic velocity between cleaning liquid 4 and intermediate medium 5 at a determined value, as set by modification unit 7, and cleaning units 42 and 43 thus no longer require an operation to change a difference in sonic velocity as described above, as occasion requires, and substrate 10 can thus be cleaned rapidly. For an explicatory example, the cleaning units 41, 42, 43 cleaning liquid 4 and the cleaning unit 41 intermediate medium 5 may all be water (pure water) of 25 degrees centigrade, and the cleaning unit 42 intermediate medium 5 may be water of 50 degrees centigrade and the cleaning unit 43 intermediate medium 5 may be water of 80 degrees centigrade. Alternatively, in an example according to the present invention, the cleaning units 41, 42, 43 cleaning liquid 4 and the cleaning unit 41 intermediate medium 5 may all be water (pure water) of 25 degrees centigrade, and the cleaning unit 42 intermediate medium 5 may be an aqueous solution with ethanol having a proportion of 50% by volume and the cleaning unit 43 intermediate medium 5 may be ethanol liquid (with ethanol having a proportion of 100%).

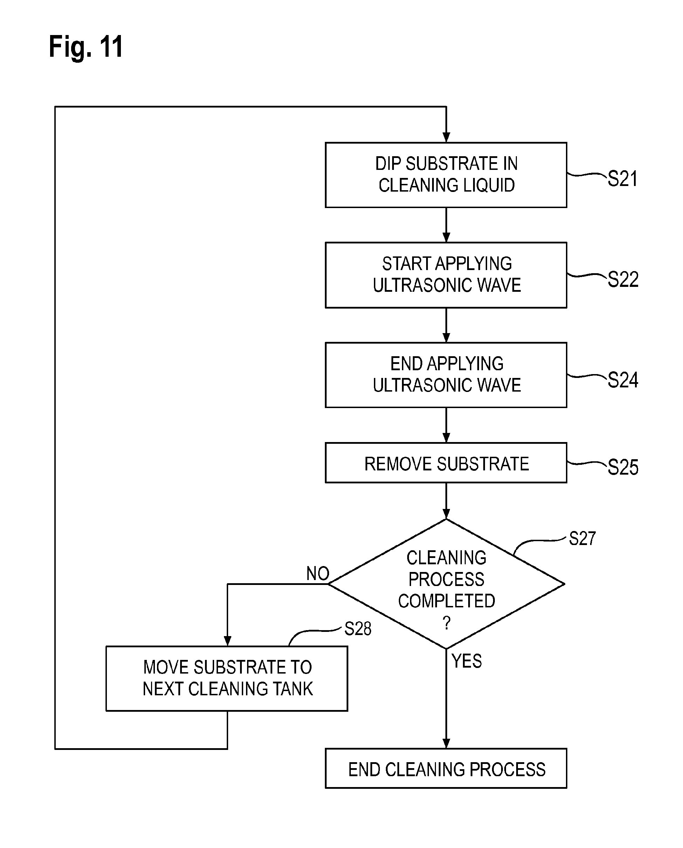

Reference will now be made to Fig. 11 to describe a cleaning method using the Fig. 10 cleaning equipment 100. As shown in Fig. 11, the cleaning method using the Fig. 10 cleaning equipment 100 is basically similar to the Fig. 3 cleaning method, except that the Fig. 3 cleaning process S20 is specifically different from the Fig. 4 process. That is, the cleaning method using the Fig. 10 cleaning equipment 100 is done as follows: substrate 10 is disposed initially in cleaning unit 41, then in cleaning unit 42, and then in cleaning unit 43 sequentially at each cleaning tank 2, and thus cleaned in each cleaning unit 41, 42, 43 sequentially.

That is, the Fig. 11 step S21 of dipping a substrate in a cleaning tank is performed by initially disposing substrate 10 in the cleaning unit 41 cleaning tank 2. Subsequently, as shown in Fig. 11, applying an ultrasonic wave is started (step S22). In this step S22, intermediate medium 5 is supplied to coupling tank 3 of cleaning unit 41, while ultrasonic wave generation unit 6 generates an ultrasonic wave. As a result, the cleaning tank 2 cleaning liquid 4 receives the ultrasonic wave, and cleaning unit 41 ultrasonically cleans substrate 10. Note that cleaning unit 41 is not provided with modification unit 7, and accordingly, the ultrasonic wave travels through cleaning tank 2 along arrow 15. Accordingly, as shown in Fig. 10, cleaning unit 41 performs cleaning with holding member 11 causing shadowed area 12.

Cleaning unit 41 provides cleaning continuously for a predetermined period of time, and thereafter, applying the ultrasonic wave ends (step S24) as shown in Fig. 11. Step S24 is similar to that of the Fig. 4 process. Then, the substrate is removed (step S25). In step S25, the substrate transfer member (not shown) removes substrate 10 from cleaning tank 2 of cleaning unit 41.

Then, as shown in Fig. 11, it is determined whether the cleaning process is completed (step S27). In step S27, it is determined whether cleaning units 41, 42, 43 have all cleaned substrate 10. This may be determined for example by using a position sensor to detect whether the substrate transfer member (or substrate 10) is located over cleaning unit 43 that performs final cleaning (i.e., whether substrate 10 has been removed from the last cleaning unit 43).

If in step S27 it is determined that the cleaning process is not completed (NO), the substrate is moved to over the next cleaning tank (step S28). Specifically, the substrate transfer member moves substrate 10 to over cleaning tank 2 of the next cleaning unit (cleaning unit 42 for example). Then, steps S21-S25 are performed in the next cleaning unit. After the cleaning units have all cleaned substrate 10 in this way, it is determined in step S27 that the cleaning process has been completed (YES). The cleaning process is thus completed.

As set forth above, cleaning units 41, 42, 43 each have a different condition applied to refract an ultrasonic wave at the bottom of cleaning tank 2 and thus cause the ultrasonic wave to travel through cleaning tank 2 in a different direction. As a result, substrate 10 cleaned by cleaning units 41, 42, 43 sequentially can have its surface cleaned substantially without an area that is not directly exposed to the ultrasonic wave (or shadowed area 12).

Hereinafter, the present invention's characteristic configurations will be enumerated, although some of them overlap the above described embodiments.

The present invention provides cleaning apparatus 1 including cleaning tank 2, coupling tank 3, ultrasonic wave generation unit 6, and modification unit 7, as shown in Fig. 1. Cleaning tank 2 holds cleaning liquid 4 for cleaning substrate 10 serving as an object to be cleaned. Coupling tank 3 holds intermediate medium 5 and cleaning tank 2 has a portion in contact with intermediate medium 5. Ultrasonic wave generation unit 6 is provided at coupling tank 3, and ultrasonically vibrates cleaning liquid 4 via intermediate medium 5. Modification unit 7 modifies a difference in sonic velocity between cleaning liquid 4 and intermediate medium 5.

This can modify a condition applied to refract an ultrasonic wave at a boundary of cleaning tank 2 and coupling tank 3. This allows the ultrasonic wave to travel through cleaning tank 2 in a modified direction and can thus reduce area 12 of the object (or substrate 10) held in cleaning liquid 4 that is shadowed by holding member 11 holding the object (i.e., an area that is not directly exposed to the ultrasonic wave).

In a cleaning apparatus 1, not forming part of the present invention, modification unit 7 may include a temperature adjustment unit to vary intermediate medium 5 in temperature, as shown in Fig. 2 (e.g., heater 17 of Fig. 2 or automatic valve 27 of Fig. 7). Adjusting intermediate medium 5 in temperature allows sonic velocity in intermediate medium 5 to be controlled without modifying intermediate medium 5 in composition or the like, and the apparatus can have a relatively simple configuration to modify a condition applied to refract an ultrasonic wave at a boundary portion of cleaning tank 2 and coupling tank 3. As a result, cleaning apparatus 1 can be manufactured at a reduced cost.

In cleaning apparatus 1, not forming part of the present invention, the temperature adjustment unit may have heater 17 as a heating member to heat intermediate medium 5. Heater 17 that can adjust intermediate medium 5 in temperature allows sonic velocity in intermediate medium 5 to be controlled without modifying intermediate medium 5 in composition or the like. This allows the apparatus to have a relatively simple configuration to modify a condition applied to refract an ultrasonic wave at a boundary portion of cleaning tank 2 and coupling tank 3. As a result, cleaning apparatus 1 can be manufactured at a reduced cost.

In cleaning apparatus 1, not forming part of the present invention, as shown in Fig. 7, intermediate medium 5 may be degassed water and the temperature adjustment unit may have a flow rate adjustment unit (or automatic valve 27) to adjust the amount of the degassed water supplied to coupling tank 3. When the degassed water is exposed to an ultrasonic wave, its temperature increases, and intermediate medium 5 can thus be adjusted in temperature without having its composition varied. Controlling intermediate medium 5 in temperature allows sonic velocity in intermediate medium 5 to be controlled, and the apparatus can have a relatively simple configuration to modify a condition applied to refract an ultrasonic wave at a boundary portion of cleaning tank 2 and coupling tank 3. As a result, cleaning apparatus 1 can be manufactured at a reduced cost.

In cleaning apparatus 1, modification unit 7 includes a composition adjustment unit to modify intermediate medium 5 in composition, as shown in Fig. 8 (e.g., automatic valves 27 and 28 shown in Fig. 8). In this case, while cleaning tank 2 and coupling tank 3 can have an internal configuration as conventional, intermediate medium 5 can be modified in composition (e.g., a liquid introduced into coupling tank 3 as intermediate medium 5 can be modified in composition to have a modified mixture ratio or the like) to control sonic velocity therein and the apparatus can dispense with a device such as a heating member such as heater 17 as shown in Fig. 2. Accordingly, cleaning tank 2 or coupling tank 3 is per se not complicated in configuration and cleaning apparatus 1 can be manufactured accordingly less expensively.

The present invention provides cleaning equipment 100 equipped with a plurality of cleaning units 41, 42, 43 to clean substrate 10 as an object to be cleaned with cleaning liquid 4, and cleaning unit 41, 42, 43 is cleaning apparatus 1 as described above. Single cleaning units 41, 42, 43 have intermediate medium 5 without having a condition varied as occasion requires. Rather, cleaning units 41, 42, 43 can each have its cleaning condition set and fixed differently. Then, substrate 10 can be cleaned for example initially in cleaning unit 41, then in cleaning unit 42, and then in cleaning unit 43 sequentially, and thus continuously cleaned. This allows more efficient cleaning and hence a less costly cleaning process. Furthermore, cleaning units 41, 42, and 43 all having a configuration of cleaning apparatus 1 of the present invention (or modification unit 7) allow a cleaning condition to be set in detail and cleaning to be done further more efficiently.

The present invention provides cleaning equipment 100 equipped with a plurality of cleaning units 41, 42, 43 to clean substrate 10 as an object to be cleaned with cleaning liquid 4, as shown in Fig. 10, and at least one of the plurality of cleaning units 41, 42, 43 (in Fig. 10, two cleaning units 42 and 43) is cleaning apparatus 1 as described above. At least one cleaning unit 42, 43 that has the configuration of cleaning apparatus 1 of the present invention, can have a condition (applied to refract an ultrasonic wave at an interface of cleaning tank 2 and intermediate medium 5) set to be different than another cleaning unit 41. This allows cleaning units 41, 42, 43 to clean substrate 10 sequentially without a surface having area 12 of a large area which is shadowed and thus not directly exposed to an ultrasonic wave.

The present invention provides a cleaning method including, as shown in Fig. 4, the steps of: disposing substrate 10 as an object to be cleaned in cleaning liquid 4 held in cleaning tank 2 (see Fig. 1) (the Fig. 4 S21); and ultrasonically vibrating cleaning liquid 4 via intermediate medium 5 (see Fig. 1) in contact with cleaning tank 2 to clean the object (or substrate 10) (the Fig. 4 steps S22-S24). The step of ultrasonically vibrating includes the steps of: ultrasonically vibrating the cleaning liquid with cleaning liquid 4 and intermediate medium 5 allowing sonic velocities, respectively, having a first difference (the Fig. 5 or 6 step S231); and ultrasonically vibrating cleaning liquid 4 with cleaning liquid 4 and intermediate medium 5 allowing sonic velocities, respectively, having a second difference different from the first difference (the Fig. 5 or 6 step S232). The first and different, second differences can vary for each cleaning step a condition applied to refract an ultrasonic wave at a boundary of cleaning tank 2 and intermediate medium 5. As a result, the object to be cleaned (e.g., substrate 10) held in cleaning liquid 4 does not have shadowed area 12 having an otherwise large area attributed to holding member 11 (i.e., an area which is not directly exposed to an ultrasonic wave).

In the step of ultrasonically vibrating, not forming part of the present invention, intermediate medium 5 may be modified in temperature to change the first difference to the second difference in sonic velocity between cleaning liquid 4 and intermediate medium 5, as has been described for the Fig. 4 step S23. Adjusting intermediate medium 5 in temperature allows sonic velocity in intermediate medium 5 to be controlled without modifying intermediate medium 5 in composition or the like. This allows the cleaning method to be performed with cleaning apparatus 1 simply configured and hence less costly including a reduced cleaning cost. Note that cleaning liquid 4 may be modified in temperature to change the first difference to the second difference.

In the step of ultrasonically vibrating, not forming part of the present invention, a heating member, or heater 17 (see Fig. 2), may be used to modify intermediate medium 5 in temperature to change the first difference to the second difference. Adjusting intermediate medium 5 in temperature allows sonic velocity to be controlled without modifying intermediate medium 5 in composition or the like. This allows the cleaning method to be performed with cleaning apparatus 1 simply configured and hence less costly including a reduced cleaning cost.

In the above cleaning method, not forming part of the present invention, as has been described with reference to Fig. 7, intermediate medium 5 may be degassed water, and in the step of ultrasonically vibrating, a retention time of the degassed water (intermediate medium 5) in contact with cleaning tank 2 may be varied to modify the degassed water in temperature to change the first difference to the second difference in sonic velocity between cleaning liquid 4 and intermediate medium 5. As degassed water exposed to an ultrasonic wave has an increased temperature, simply controlling the flow rate of intermediate medium 5 (or degassed water) allows intermediate medium 5 to be controlled in temperature without modifying intermediate medium 5 in composition. This can in turn control sonic velocity in intermediate medium 5, and the present cleaning method can be performed without substantially modifying the configuration of cleaning apparatus 1 as conventional. This can prevent the cleaning method's cost from increasing.

In the step of ultrasonically vibrating, in accordance with the present invention, intermediate medium 5 may be modified in composition to change the first difference to the second difference in sonic velocity between cleaning liquid 4 and intermediate medium 5, as done when the Fig. 8 cleaning apparatus 1 is used. In this case, while cleaning apparatus 1 can be configured of cleaning tank 2, coupling tank 3 and the like having an internal configuration as conventional, intermediate medium 5 conveyed can be modified in composition (i.e., a liquid introduced as intermediate medium 5 can be modified in composition or to have a modified mixture ratio or the like) to control sonic velocity therein, and the

Fig. 2 heater 17 or a similar heating member can be dispensed with. Cleaning tank 2, coupling tank 3 and the like per se are thus not complicated in configuration.

The step of ultrasonically vibrating may further include one or more steps of ultrasonically vibrating cleaning liquid 4 with cleaning liquid 4 and intermediate medium 5 allowing sonic velocities, respectively, having a difference different from the first and second differences, as done when the Fig. 10 cleaning equipment 100 is used. In this case, setting three or more conditions applied to refract an ultrasonic wave at a contact interface of cleaning tank 2 and intermediate medium 5 can more effectively reduce an area of an object to be cleaned, or substrate 10, that is not directly exposed to the ultrasonic wave (i.e., shadowed area 12). This ensures that substrate 10 is cleaned.

The present invention provides a cleaning method including the steps of: disposing an object to be cleaned (substrate 10) in a first cleaning liquid 4 held in a first cleaning tank (e.g., cleaning tank 2 of cleaning unit 42 of Fig. 10) (the Fig. 11 step S21); ultrasonically vibrating the first cleaning liquid via a first intermediate medium in contact with the first cleaning tank (intermediate medium 5 of cleaning unit 42 of Fig. 10) to clean the object (the Fig. 11 steps S22-S24); disposing the object (substrate 10) in a second cleaning liquid 4 held in a second cleaning tank (e.g., cleaning tank 2 of cleaning unit 43 of Fig. 10) (the Fig. 11 step S21 performed after the Fig. 11 step S28); and ultrasonically vibrating the second cleaning liquid via a second intermediate medium in contact with the second cleaning tank (intermediate medium 5 of cleaning unit 43 of Fig. 10) to clean the object (the Fig. 11 steps S22-S24). A first difference in sonic velocity between the first cleaning liquid and the first intermediate medium (e.g., a condition applied to cleaning unit 42 to refract an ultrasonic wave) and a second difference in sonic velocity between the second cleaning liquid and the second intermediate medium (e.g., a condition applied to cleaning unit 43 to refract an ultrasonic wave), are different from each other.

In contrast to the Fig. 2 cleaning apparatus 1, a single coupling tank 3 holds intermediate medium 5 without having the intermediate medium's condition modified as occasion would require. Rather, first and second intermediate media's respective conditions can be fixed, and substrate 10 can thus be cleaned continuously. This allows substrate 10 to be cleaned in a more efficient and hence less costly method.

If the above cleaning method, not forming part of the present invention, is performed with the Fig. 10 cleaning equipment 100 having cleaning units 42 and 43 implemented by the Fig. 2 or Fig. 7 cleaning apparatus 1, at least one of the first intermediate medium (e.g., intermediate medium 5 of cleaning unit 42) and the second intermediate medium (e.g., intermediate medium 5 of cleaning unit 43) may be adjusted in temperature to set the first difference and the second difference differently. Varying the first or second intermediate medium in temperature can in turn vary sonic velocity in the intermediate medium and hence an angle of refraction of an ultrasonic wave at a contact interface of cleaning tank 2 and intermediate medium 5 (i.e., at a bottom surface of cleaning tank 2). This allows sonic velocity in intermediate medium 5 to be modified without modifying intermediate medium 5 in composition or the like. The cleaning method can thus be performed with cleaning equipment 100 relatively simply configured and hence less costly including a reduced cleaning cost.

If the above cleaning method, not forming part of the present invention, is performed with the Fig. 10 cleaning equipment 100 such that one of cleaning units 42 and 43 is implemented by the Fig. 2 cleaning apparatus 1, at least one of the first intermediate medium and the second intermediate medium may be adjusted in temperature by modification unit 7 including a heating member (heater 17). Adjusting intermediate medium 5 in temperature allows sonic velocity in intermediate medium 5 to be controlled without modifying intermediate medium 5 in composition or the like, and the cleaning method can be performed with cleaning equipment 100 relatively simply configured and hence less costly including a reduced cleaning cost.

If the above cleaning method, not forming part of the present invention, is performed with the Fig. 10 cleaning equipment 100 having cleaning unit 42 implemented by the Fig. 7 cleaning apparatus 1, the first intermediate medium (intermediate medium 5 of cleaning unit 42) may be degassed water, and a retention time of first intermediate medium 5 in contact with first cleaning tank 2 may be modified to set the temperature of first intermediate medium 5 to be different from that of the second intermediate medium (intermediate medium 5 of cleaning unit 43). As degassed water exposed to an ultrasonic wave has an increased temperature, simply controlling the flow rate of intermediate medium 5 allows intermediate medium 5 to be controlled in temperature without modifying intermediate medium 5 in composition. This can in turn control sonic velocity in intermediate medium 5, and the present cleaning method can be performed without substantially modifying the configuration of cleaning equipment 100 as conventional. This can prevent the cleaning method's cost from increasing.

If the above cleaning method is performed with the Fig. 10 cleaning equipment 100 such that at least one of cleaning units 42 and 43 is implemented by the Fig. 8 cleaning apparatus 1, the first intermediate medium and the second intermediate medium may have mutually different compositions so that a first difference in sonic velocity between the first cleaning liquid and the first intermediate medium and a second difference in sonic velocity between the second cleaning liquid and the second intermediate medium may be different from each other. In this case, while the cleaning method can be performed with cleaning tank 2 and the like having an internal configuration as conventional, intermediate medium 5 conveyed can be modified in composition (i.e., a liquid introduced as intermediate medium 5 can be modified in composition or to have a modified mixture ratio or the like) to control sonic velocity therein, and cleaning equipment 100 can thus dispense with a heating member or the like. Cleaning equipment 100 thus does not have cleaning tank 2 or the like complicated in configuration.

### Example

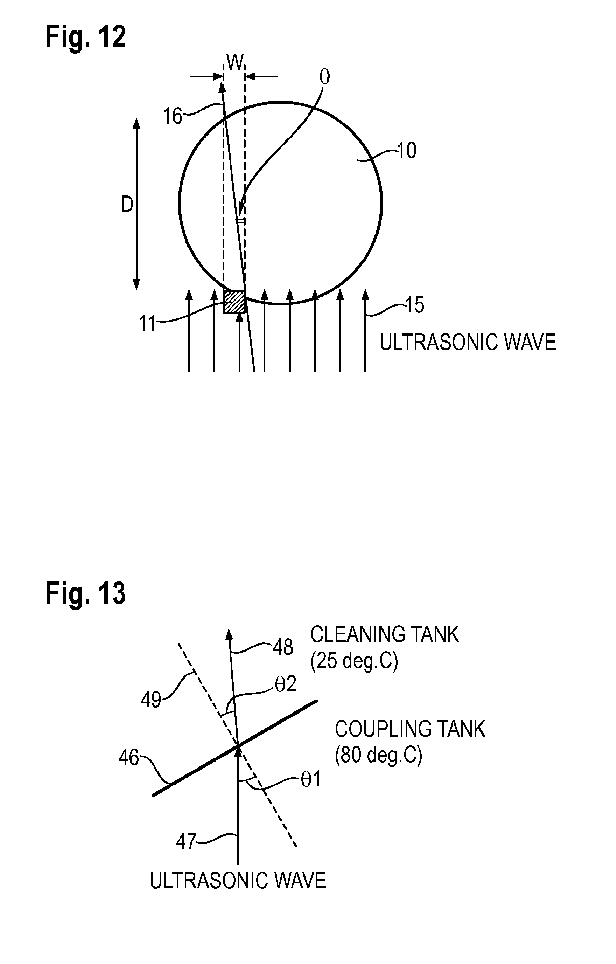

A study has been done for a desirable angle of refraction of an ultrasonic wave at a bottom of cleaning tank 2, as will be described hereinafter with reference to Fig. 12.

With reference to Fig. 12, herein, substrate 10 of 300 mm in diameter is held by holding member 11 of a width W for the sake of illustration. Holding member 11 shadows a portion having a length D of 250 mm and holding member 11 has width W of 4 mm for the sake of illustration. If an ultrasonic wave traveling along arrow 15 is refracted at an angle θ of 0.9 degree, an area of substrate 10 that is shadowed by holding member 11 and thus not directly exposed to the ultrasonic wave (i.e., shadowed area 12 shown in Fig. 1) can approximately be halved. Accordingly, a targeted value of angle of refraction θ of the ultrasonic wave can be set at one degree for example. Note that if angle of refraction θ is set to have a value larger than one degree, the area shadowed by holding member 11 can further be reduced.

Then, a study has been done for an angle of refraction of an ultrasonic wave in the Fig. 2 cleaning apparatus 1. A result of the study will be described hereinafter with reference to Fig. 13.

As shown in Fig. 13, the Fig. 2 cleaning apparatus 1 has ultrasonic wave generation unit 6 (see Fig. 2) emitting an ultrasonic wave, which in turn travels along an arrow 47, and is incident on the cleaning tank at bottom surface 46 at an angle represented as θ1 and emitted therefrom at an angle represented as θ2 for the sake of illustration. Note that angle of incidence θ1 is an angle formed by a perpendicular 49 to bottom surface 46 of the cleaning tank and arrow 47 (a direction in which an incident ultrasonic wave travels). Furthermore, angle of emittance θ2 is an angle formed by perpendicular 49 to bottom surface 46 of the cleaning tank and an arrow 48 (a direction in which an emitted ultrasonic wave travels). Note that arrow 47 corresponds to the vertical direction, and accordingly, angle of incidence θ1 is identical to the angle of inclination of bottom surface 46 of the cleaning tank relative to the horizontal direction.

Herein, the cleaning tank contains cleaning liquid 4 (see Fig. 2) of pure water having a temperature of 25 degrees centigrade and coupling tank 3 (see Fig. 2) contains intermediate medium 5 (see Fig. 2) of pure water having a temperature of 80 degrees centigrade for the sake of illustration. In this case, cleaning liquid 4 allows sonic velocity of approximately 1,495 m/s therein, and intermediate medium 5 allows sonic velocity of approximately 1,573 m/s therein. Under such conditions, angle of incidence θ1 was varied from 5 to 60 degrees (i.e., the cleaning tank had bottom surface 46 inclined at a varying angle) and angle of emittance θ2 was calculated. The result is shown in Table 1.

**Table 1**

| angle of incidence: θ1 (degrees) | angle of emittance: θ2 (degrees) | angular variation (degrees) |
|---|---|---|
| 5 | 4.8 | -0.2 |
| 10 | 9.5 | -0.5 |
| 15 | 14.3 | -0.7 |
| 20 | 19.0 | -1.0 |
| 25 | 23.7 | -1.3 |
| 30 | 28.4 | -1.6 |
| 35 | 33.1 | -1.9 |
| 40 | 37.7 | -2.3 |
| 45 | 42.3 | -2.7 |
| 50 | 46.9 | -3.1 |
| 55 | 51.3 | -3.7 |
| 60 | 55.6 | -4.4 |

Table 1 shows angle of incidence θ1 (angle of incidence on the bottom surface of the cleaning tank, which is identical to the inclination of the bottom surface of the cleaning tank if the ultrasonic waves travel in vertical direction), angle of emittance θ2, and an angular variation. Note that the angular variation is calculated as an angle of emittance minus an angle of incidence. As can be seen from Table 1, the angular variation (or angle of refraction θ of Fig. 12) is one degree or larger for angle of incidence θ1 of 20 degrees or larger. Accordingly, when cleaning liquid 4 and intermediate medium 5 conditioned as above are used, angle of incidence θ1 (i.e., cleaning tank 2 having a bottom surface inclined at an angle) of 20 degrees or larger allows an ultrasonic wave to be refracted at a sufficiently large angle.

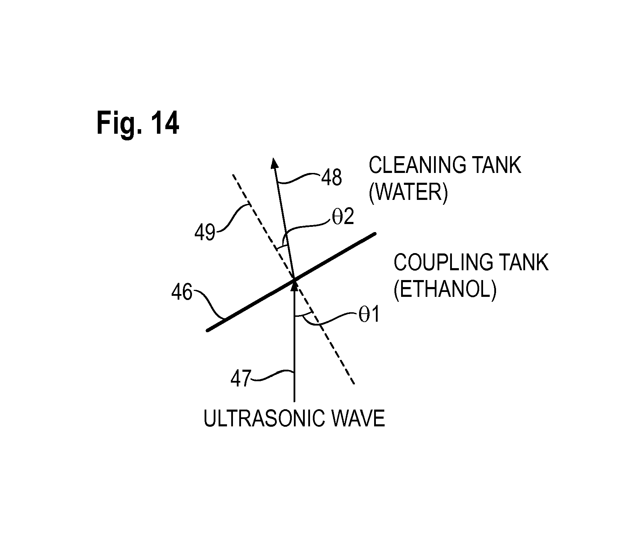

Then, a study has been done for an angle of refraction of an ultrasonic wave in the Fig. 8 cleaning apparatus 1. A result of the study will be described with reference to Fig. 14.

As shown in Fig. 14, the Fig. 8 cleaning apparatus 1, as well as the Fig. 2 cleaning apparatus 1, has ultrasonic wave generation unit 6 (see Fig. 8) emitting an ultrasonic wave, which in turn travels along arrow 47, and is incident on the cleaning tank at bottom surface 46 at an angle represented as θ1 and emitted therefrom at an angle represented as θ2 for the sake of illustration. Angle of incidence θ1, angle of emittance θ2, and the like are defined as have been done with reference to Fig. 13.

Herein, the cleaning tank contains cleaning liquid 4 (see Fig. 8) of pure water having a temperature of 25 degrees centigrade and coupling tank 3 (see Fig. 8) contains intermediate medium 5 (see Fig. 8) of ethanol having a temperature of 25 degrees centigrade for the sake of illustration. In this case, cleaning liquid 4 allows sonic velocity of approximately 1,495 m/s therein, and intermediate medium 5 allows sonic velocity of approximately 1,144 m/s therein. Under such conditions, angle of incidence θ1 was varied from 5 to 45 degrees (i.e., the cleaning tank had bottom surface 46 inclined at a varying angle) and angle of emittance θ2 was calculated. The result is shown in Table 2.

**Table 2**

| angle of incidence: θ1 (degrees) | angle of emittance: θ2 (degrees) | angular variation (degrees) |
|---|---|---|
| 5 | 6.5 | 1.5 |
| 10 | 13.1 | 3.1 |
| 15 | 19.8 | 4.8 |
| 20 | 26.6 | 6.6 |
| 25 | 33.5 | 8.5 |
| 30 | 40.8 | 10.8 |
| 35 | 48.6 | 13.6 |
| 40 | 57.2 | 17.2 |
| 45 | 67.5 | 22.5 |

Table 2, as well as table 1, shows angle of incidence θ1, angle of emittance θ2, and an angular variation. Note that the angular variation is calculated as an angle of emittance minus an angle of incidence, similarly as indicated in table 1. As can be seen from table 2, the angular variation (or angle of refraction θ of Fig. 12) is 1.5 degree or larger for angle of incidence θ1 of 5 degrees or larger. Furthermore, if the angle of incidence θ1 is 30 degrees or larger, the angular variation is 10 degrees or larger. Accordingly, when cleaning liquid 4 and intermediate medium 5 conditioned as above are used, angle of incidence θ1 (i.e., cleaning tank 2 having a bottom surface inclined at an angle) of 5 degrees or larger allows an ultrasonic wave to be refracted at a sufficiently large angle.

It should be understood that the embodiments and examples disclosed herein are illustrative and non-restrictive in any respect. The scope of the present invention is defined by the terms of the claims, rather than the description above, and is intended to include any modifications within the scope and meaning equivalent to the terms of the claims.

### Industrial Applicability

The present invention is advantageously applicable to ultrasonic cleaning apparatuses and methods, in particular.

## Claims

1. A cleaning apparatus (1) comprising:
- a cleaning tank (2) holding a cleaning liquid (4) for cleaning an object (10) to be cleaned,
- a coupling tank (3) holding an intermediate medium (5) and disposed such that said cleaning tank (2) has a portion in contact with said intermediate medium (5),
- the bottom of the cleaning tank (2) inclines relative to that of the coupling tank (3)
- an ultrasonic wave generation unit (6) provided at said coupling tank (3) and ultrasonically vibrating said cleaning liquid (4) via said intermediate medium (5),
wherein a modification unit (7) which includes a composition adjustment unit modifying said intermediate medium (5) in composition modifies a difference in sonic velocity between said cleaning liquid (4) and said intermediate medium (5) to refract an ultrasonic wave that is emitted from ultrasonic wave generation unit (6).

2. Cleaning equipment equipped with a plurality of cleaning units cleaning an object to be cleaned with a cleaning liquid, at least one of said plurality of cleaning units being the cleaning apparatus of claim 1.

3. A cleaning method, using a cleaning apparatus as per claim 1, comprising the steps of:
- disposing in a cleaning liquid (4) held in a cleaning tank (2) an object (10) to be cleaned; and
- the bottom of the cleaning tank (2) inclines relative to that of the coupling tank (3)
- ultrasonically vibrating said cleaning liquid (4) via an intermediate medium (5) in contact with said cleaning tank (2) to clean said object, wherein the step of ultrasonically vibrating include the steps of:
- ultrasonically vibrating said cleaning liquid (4), with said cleaning liquid and said intermediate medium (5) allowing sonic velocities, respectively, having a first difference; and
- ultrasonically vibrating said cleaning liquid (4), with said cleaning liquid (4) and said intermediate medium (5) allowing sonic velocities, respectively, having a second difference different from said first difference to refract an ultrasonic wave at a boundary of the cleaning tank (2) and the coupling tank (3) wherein a modification unit (7) which includes a composition adjustment unit modifying said intermediate medium (5) in composition modifies a difference in sonic velocity between said cleaning liquid (4) and said intermediate medium (5) to refract an ultrasonic wave that is emitted from ultrasonic wave generation unit (6).

4. The cleaning method according to claim 3, wherein in the step of ultrasonically vibrating, said intermediate medium (5) is modified in composition to change said first difference to said second difference in sonic velocity between said cleaning liquid (4) and said intermediate medium (5).

5. The cleaning method according to claim 4, wherein the step of ultrasonically vibrating further includes one or more steps of ultrasonically vibrating said cleaning liquid (4), with said cleaning liquid (4) and said intermediate medium (5) allowing sonic velocities, respectively, having a difference different from said first and second differences.

6. A cleaning method , using a cleaning equipment as per claim 2, comprising the steps of:
- disposing in a first cleaning liquid (4) held in a first cleaning tank (2) an object (10) to be cleaned;
- the bottom of the cleaning tank (2) inclines relative to that of the coupling tank (3)
- ultrasonically vibrating said first cleaning liquid (4) via a first intermediate medium (5) in contact with said first cleaning tank (2) to clean said object;
- disposing said object in a second cleaning liquid (4) held in a second cleaning tank (2); and
- ultrasonically vibrating said second cleaning liquid (4) via a second intermediate medium (5) in contact with said second cleaning tank (2) to clean said object, wherein said first cleaning liquid (4) and said first intermediate medium (5) allowing sonic velocities, respectively, having a first difference, said second cleaning liquid (4) and said second intermediate medium (5) allowing sonic velocities, respectively, having a second difference, said first and second differences being different from each other and wherein a modification unit (7), which includes a composition adjustment unit modifying said intermediate medium (5) in composition , or modifies a difference in sonic velocity between said cleaning liquid (4) and said intermediate medium (5) to refract an ultrasonic wave that is emitted from ultrasonic wave generation unit (6).

7. The cleaning method according to claim 6, wherein said first intermediate medium (5) and said second intermediate medium (5) have mutually different compositions so that a first difference in sonic velocity between said first cleaning liquid (4) and said first intermediate medium (5) and a second difference in sonic velocity between said second cleaning liquid (4) and said second intermediate medium (5) are different from each other.

## Patentansprüche

1. Reinigungsvorrichtung (1), die Folgendes umfasst:
- einen Reinigungstank (2), der eine Reinigungsflüssigkeit (4) zum Reinigen eines zu reinigenden Objektes (10) enthält,
- einen Verbindungstank (3), der ein Zwischenmedium (5) enthält und so angeordnet ist, dass der Reinigungstank (2) einen Abschnitt in Kontakt mit dem Zwischenmedium (5) besitzt,
- wobei der Boden des Reinigungstanks (2) in Bezug auf den Boden des Verbindungstanks (3) geneigt ist,
- eine Ultraschallwellen-Erzeugungseinheit (6), die bei dem Verbindungstank (3) bereitgestellt ist und die mittels Ultraschall die Reinigungsflüssigkeit (4) über das Zwischenmedium (5) vibrieren lässt,
wobei eine Änderungseinheit (7), die eine Zusammensetzungs-Anpassungseinheit enthält, die das Zwischenmedium (5) in der Zusammensetzung verändert, einen Unterschied der Schallgeschwindigkeit zwischen der Reinigungsflüssigkeit (4) und dem Zwischenmedium (5) verändert, um eine Ultraschallwelle, die von der Ultraschallwellen-Erzeugungseinheit (6) emittiert worden ist, zu brechen.

2. Reinigungsanlage, die mit mehreren Reinigungseinheiten ausgestattet ist, die ein zu reinigendes Objekt mit einer Reinigungsflüssigkeit reinigen, wobei mindestens eine der mehreren Reinigungseinheiten die Reinigungsvorrichtung nach Anspruch 1 ist.

3. Reinigungsverfahren, das eine Reinigungsvorrichtung nach Anspruch 1 verwendet und das die folgenden Schritte umfasst:
- Anordnen eines Objektes (10), das zu reinigen ist, in einer Reinigungsflüssigkeit (4), die in einem Reinigungstank (2) enthalten ist; und
- Neigen des Bodens des Reinigungstanks (2) in Bezug auf den Boden des Verbindungstanks (3),
- Vibrierenlassen der Reinigungsflüssigkeit (4) mittels Ultraschall über ein Zwischenmedium (5), das in Kontakt mit dem Reinigungstank (2) steht, um das Objekt zu reinigen, wobei der Schritt des Vibrierens mittels Ultraschall die folgenden Schritte umfasst:
- Vibrierenlassen der Reinigungsflüssigkeit (4) mittels Ultraschall mit der Reinigungsflüssigkeit und dem Zwischenmedium (5), derart, dass ermöglicht wird, dass die Schallgeschwindigkeiten jeweils einen ersten Unterschied besitzen; und
- Vibrierenlassen der Reinigungsflüssigkeit (4) mittels Ultraschall mit der Reinigungsflüssigkeit (4) und dem Zwischenmedium (5), derart, dass ermöglicht wird, dass die Schallgeschwindigkeiten jeweils einen zweiten Unterschied besitzen, der sich von dem ersten Unterschied unterscheidet, um eine Ultraschallwelle an einer Grenze des Reinigungstanks (2) und des Verbindungstanks (3) zu brechen, wobei eine Veränderungseinheit (7), die eine Zusammensetzungs-Anpassungseinheit enthält, die das Zwischenmedium (5) verändert, in der Zusammensetzung einen Unterschied der Schallgeschwindigkeit zwischen der Reinigungsflüssigkeit (4) und dem Zwischenmedium (5) verändert, um eine Ultraschallwelle, die von der Ultraschallwellen-Erzeugungseinheit (6) emittiert worden ist, zu brechen.

4. Reinigungsverfahren nach Anspruch 3, wobei in dem Schritt des Vibrierenlassens mittels Ultraschall das Zwischenmedium (5) in der Zusammensetzung verändert wird, um den ersten Unterschied in den zweiten Unterschied der Schallgeschwindigkeit zwischen der Reinigungsflüssigkeit (4) und dem Zwischenmedium (5) zu verändern.

5. Reinigungsverfahren nach Anspruch 4, wobei der Schritt des Vibrierenlassens mittels Ultraschall ferner einen oder mehrere Schritte des Vibrierenlassens mittels Ultraschall der Reinigungsflüssigkeit (4) mit der Reinigungsflüssigkeit (4) und dem Zwischenmedium (5) enthält, derart, dass ermöglicht wird, dass die Schallgeschwindigkeiten jeweils einen Unterschied besitzen, der sich von dem ersten und von dem zweiten Unterschied unterscheidet.

6. Reinigungsverfahren, das eine Reinigungsanlage nach Anspruch 2 verwendet und das die folgenden Schritte umfasst:
- Anordnen eines Objektes (10), das zu reinigen ist, in einer ersten Reinigungsflüssigkeit (4), die in einem ersten Reinigungstank (2) enthalten ist;
- Neigen des Bodens des Reinigungstanks (2) in Bezug auf den Boden des Verbindungstanks (3),
- Vibrierenlassen der ersten Reinigungsflüssigkeit (4) mittels Ultraschall über ein erstes Zwischenmedium (5), das in Kontakt mit dem Reinigungstank (2) steht, um das Objekt zu reinigen;
- Anordnen des Objekts in einer zweiten Reinigungsflüssigkeit (4), die in einem zweiten Reinigungstank (2) enthalten ist; und
- Vibrierenlassen der zweiten Reinigungsflüssigkeit (4) mittels Ultraschall über ein zweites Zwischenmedium (5), das in Kontakt mit dem zweiten Reinigungstank (2) steht, um das Objekt zu reinigen, wobei die erste Reinigungsflüssigkeit (4) und das erste Zwischenmedium (5) ermöglichen, dass die Schallgeschwindigkeiten jeweils einen ersten Unterschied besitzen, die zweite Reinigungsflüssigkeit (4) und das zweite Zwischenmedium (5) ermöglichen, dass die Schallgeschwindigkeiten jeweils einen zweiten Unterschied besitzen, wobei sich der erste und der zweite Unterschied voneinander unterscheiden und wobei eine Änderungseinheit (7), die eine Zusammensetzungs-Anpassungseinheit enthält, die das Zwischenmedium (5) in der Zusammensetzung verändert, einen Unterschied der Schallgeschwindigkeit zwischen der Reinigungsflüssigkeit (4) und dem Zwischenmedium (5) verändert, um eine Ultraschallwelle, die von der Ultraschallwellen-Erzeugungseinheit (6) emittiert worden ist, zu brechen.

7. Reinigungsverfahren nach Anspruch 6, wobei das erste Zwischenmedium (5) und das zweite Zwischenmedium (5) gegenseitig unterschiedliche Zusammensetzungen besitzen, derart, dass sich ein erster Unterschied der Schallgeschwindigkeit zwischen der ersten Reinigungsflüssigkeit (4) und dem ersten Zwischenmedium (5) und ein zweiter Unterschied der Schallgeschwindigkeit zwischen der zweiten Reinigungsflüssigkeit (4) und dem zweiten Zwischenmedium (5) voneinander unterscheiden.

## Revendications

1. Appareil de nettoyage (1), comprenant :
une cuve de nettoyage (2) qui retient un liquide de nettoyage (4) servant à nettoyer un objet (10) à nettoyer,
une cuve de raccordement (3) qui conserve un fluide intermédiaire (5) et disposée de telle sorte que ladite cuve de nettoyage (2) présente une partie en contact avec ledit fluide intermédiaire (5),
le fond de la cuve de nettoyage (2) étant incliné par rapport à celui de la cuve de raccordement (3),
une unité (6) de production d'ondes ultrasoniques prévue sur ladite cuve de raccordement (3) et mettant en vibration ultrasonique ledit liquide de nettoyage (4) par l'intermédiaire dudit fluide (5),
une unité de modification (7) qui comprend une unité d'ajustement de composition modifiant la composition dudit fluide intermédiaire (5) pour modifier la différence de vitesse du son entre le liquide de nettoyage (4) et ledit fluide intermédiaire (5) de manière à réfracter l'onde ultrasonique émise par l'unité (6) de production d'ondes ultrasoniques.

2. Equipement de nettoyage doté de plusieurs unités de nettoyage nettoyant un objet à nettoyer à l'aide d'un liquide de nettoyage, au moins l'une desdites différentes unités de nettoyage étant l'appareil de nettoyage selon la revendication 1.

3. Procédé de nettoyage recourant à un appareil de nettoyage selon la revendication 1, le procédé comprenant les étapes qui consistent à :
disposer un objet (10) à nettoyer dans un liquide de nettoyage (4) retenu dans une cuve de nettoyage (2) et
le fond de la cuve de nettoyage (2) étant incliné par rapport à celui de la cuve de raccordement (3),
mettre en vibration ultrasonique ledit liquide de nettoyage (4) par l'intermédiaire d'un fluide intermédiaire (5) en contact avec ladite cuve de nettoyage (2) de manière à nettoyer ledit objet, l'étape consistant à mettre en vibration ultrasonique comprenant les étapes qui consistent à :
mettre en vibration ultrasonique ledit liquide de nettoyage (4), ledit liquide de nettoyage et ledit fluide intermédiaire (5) permettant des vitesses du son respectives présentant une première différence et
mettre en vibration ultrasonique ledit liquide de nettoyage (4), ledit liquide de nettoyage (4) et ledit fluide intermédiaire (5) permettant des vitesses du son respectives présentant une deuxième différence, différente de ladite première différence, de manière à réfracter l'onde ultrasonique à la frontière de la cuve de nettoyage (2) et de la cuve de raccordement (3),
une unité de modification (7) qui comprend une unité d'ajustement de composition modifiant la composition dudit fluide intermédiaire (5) en vue de modifier la différence de vitesse du son entre le liquide de nettoyage (4) et ledit fluide intermédiaire (5) de manière à réfracter l'onde ultrasonique émise par l'unité (6) de production d'ondes ultrasoniques.

4. Procédé de nettoyage selon la revendication 3, dans lequel, au cours de l'étape de mise en vibration ultrasonique, ledit fluide intermédiaire (5) voit sa composition modifiée de manière à modifier ladite première différence vers ladite deuxième différence de vitesse du son entre ledit liquide de nettoyage (4) et ledit fluide intermédiaire (5).

5. Procédé de nettoyage selon la revendication 4, dans lequel l'étape de mise en vibration ultrasonique comprend en outre une ou plusieurs étapes de mise en vibration ultrasonique dudit liquide de nettoyage (4), ledit liquide de nettoyage (4) et ledit fluide intermédiaire (5) permettant des vitesses du son respectives présentant une différence différente de ladite première et de ladite deuxième différence.

6. Procédé de nettoyage recourant à un équipement de nettoyage selon la revendication 2 et comprenant les étapes qui consistent à :
disposer un objet (10) à nettoyer dans un premier liquide de nettoyage (4) maintenu dans une première cuve de nettoyage (2),
le fond de la cuve de nettoyage (2) étant incliné par rapport à celui de la cuve de raccordement (3),
mettre en vibration ultrasonique ledit premier liquide de nettoyage (4) par l'intermédiaire d'un premier fluide intermédiaire (5) en contact avec ladite première cuve de nettoyage (2) de manière à nettoyer ledit objet,
disposer ledit objet dans un deuxième liquide de nettoyage (4) maintenu dans une deuxième cuve de nettoyage (2) et
mettre en vibration ultrasonique ledit deuxième liquide de nettoyage (4) par l'intermédiaire d'un deuxième fluide intermédiaire (5) en contact avec ladite deuxième cuve de nettoyage (2) pour nettoyer ledit objet,
ledit premier liquide de nettoyage (4) et ledit premier fluide intermédiaire (5) permettant des vitesses du son respectives présentant une première différence, ledit deuxième liquide de nettoyage (4) et ledit deuxième fluide intermédiaire (5) permettant des vitesses du son respectives qui présentent une deuxième différence, ladite première et ladite deuxième différence étant différentes l'une de l'autre,
une unité de modification (7) qui comprend une unité d'ajustement de composition modifiant la composition dudit fluide intermédiaire (5) de manière à modifier la vitesse du son dans ledit liquide de nettoyage (4) et dans ledit fluide intermédiaire (5) de manière à réfracter l'onde ultrasonique émise par une unité (6) de production d'ondes ultrasoniques.

7. Procédé de nettoyage selon la revendication 6, dans lequel ledit premier fluide intermédiaire (5) et ledit deuxième fluide intermédiaire (5) présentent des compositions mutuellement différentes de telle sorte qu'une première différence de vitesse du son entre ledit premier liquide de nettoyage (4) et ledit premier fluide intermédiaire (5) et une deuxième différence de vitesse du son entre ledit deuxième liquide de nettoyage (4) et ledit deuxième fluide intermédiaire (5) soient différentes l'une de l'autre.
